(19)

Europäisches Patentamt
European Patent Office
Office européen des brevets

(11)    **EP 2 367 301 A1**

(12)    **EUROPEAN PATENT APPLICATION**

(43) Date of publication:
    **21.09.2011 Bulletin 2011/38**

(51) Int Cl.:
    **H04B 10/155** $^{(2006.01)}$    **H01S 5/50** $^{(2006.01)}$

(21) Application number: **10156342.7**

(22) Date of filing: **12.03.2010**

(84) Designated Contracting States:
    **AT BE BG CH CY CZ DE DK EE ES FI FR GB GR HR HU IE IS IT LI LT LU LV MC MK MT NL NO PL PT RO SE SI SK SM TR**
    Designated Extension States:
    **AL BA ME RS**

(71) Applicant: **Nokia Siemens Networks Oy
    02610 Espoo (FI)**

(72) Inventors:
    • **Silveira, Tiago
      3780-523 Sangalhos (PT)**
    • **Ferreira, Ana
      3750-866 Borralha
      Agueda (PT)**

(54)    **Optical modulator**

(57)    An optical modulator and a method for operating an optical modulator are provided, wherein the optical modulator comprises at least two semiconductor optical amplifier sections that are arranged in a cascaded structure, wherein an information signal is applicable to one of the semiconductor optical amplifier sections and an inverse information signal is applicable to another of the semiconductor optical amplifier sections. In addition, a communication system comprising at least one such modulator is suggested.

# Fig.2

**Description**

The invention relates to an optical modulator and to a method for operating an optical modulator. In addition, a communication system comprising at least one such modulator is suggested.

The fast growth of data exchange has led to an increasing demand for transmission bandwidth. Dense wavelength division multiplexing (DWDM) networks offer high capacity transmission, both in core and/or backhaul and access and/or metro networks.

Cost efficient DWDM networks are enabled by the use of advanced modulation formats, such as differential binary phase shift keying (DPSK), differential quadrature phase shift keying (DQPSK), duobinary, carrier-suppressed return-to-zero (CS-RZ), or optical single sideband (OSSB), etc.

To generate optical signals with such modulation formats, it is required to control the phase and amplitude of the optical signal. For such purpose Mach-Zehnder modulators (MZMs) are commonly employed; however, the MZMs have high insertion losses (around 6 dB) and are considered expensive for access and radio-over-fiber applications. Directly modulated lasers have been utilized for such purposes, but the resulting amplitude modulated signals also present undesired phase distortion or reduced amplitude extinction ratio.

The **problem** to be solved is to avoid the disadvantages stated above and in particular to provide a cost-efficient solution of a modulator that is capable of modulating the amplitude or the amplitude and phase. The modulator may further be based on SOA technology.

This problem is solved according to the features of the independent claims. Further embodiments result from the depending claims.

In order to overcome this problem, an optical modulator is provided

- comprising at least two semiconductor optical amplifier sections that are arranged in a cascaded structure;
- wherein an information signal is applicable to one of the semiconductor optical amplifier sections and an inverse information signal is applicable to another of the semiconductor optical amplifier sections.

It is noted that the cascaded structure may refer to a series of SOAs, where each SOA sends its output to the input of the next SOA in a daisy chain.

Hence, the modulator may provide amplitude modulation with negligible phase modulation based on a semiconductor optical amplifier (SOA) structure. This modulator allows for an independent control of the optical signal amplitude modulation and phase modulation in a single device.

This approach facilitates optical modulators of low-cost and with low insertion losses, which are a key issue in access and radio over fiber (RoF) DWDM networks. Providing an independent control over the optical phase and amplitude enables generation of optical signals with advanced modulation formats. The solution suggested in particular supports pure amplitude modulated optical signals or optical signals with independent amplitude and phase modulation. As the structure is an SOA, an overall optical gain can be expected.

In an embodiment, the modulator may be used for or it may facilitate

- OSSB modulation;
- DPSK modulation;
- DQPSK modulation;
- CS-RZ modulation;
- substantially chirp-free OOK modulation.

In another embodiment, the modulator comprises two, three or four semiconductor optical amplifier sections.

Basically, several SOA sections could be arranged in cascaded structure. Preferably, two SOA sections are used, a first one for the information signal to be applied and a second one for the inverse information signal - preferably multiplied by a factor K - to be applied.

In a further embodiment, the inverse information signal is multiplied by a factor K.

In a next embodiment, the factor K amounts to $K = \alpha_2 / \alpha_1$, wherein $\alpha_1$ describes a ratio between the amplitude modulation and the phase modulation of a first semiconductor optical amplifier section and $\alpha_2$ describes a ratio between the amplitude modulation and the phase modulation of a second semiconductor optical amplifier section.

It is noted that $\alpha_2$, $\alpha_1$ are also referred to as linewidth enhancement factors. It is also noted that the modulator may comprise in particular two semiconductor optical amplifier sections.

It is also noted that in case $\alpha_1 \gg \alpha_2$ and $K \ll 1$, the modulator does predominately show amplitude modulation and no (or nearly no) phase modulation.

It is also an embodiment that the ratio between the amplitude modulation and the phase modulation of the first semiconductor optical amplifier section and the ratio between the amplitude modulation and the phase modulation of the second semiconductor optical amplifier section are controlled by, e.g., a bias current or by amplifier design.

Said bias current may be a bias DC current.

Pursuant to another embodiment, the semiconductor optical amplifier section driven by bias current of lower amplitude is arranged in prior to a subsequent semiconductor optical amplifier section that is driven by the bias current of higher amplitude.

According to an embodiment, the modulator is used in an access network or in a radio-over-fiber network.

According to another embodiment, at least two subsequent semiconductor optical amplifier sections are arranged for phase modulation purposes.

Hence, the information signal may be an electrical signal driving the phase modulation stage.

In yet another embodiment, at least two subsequent semiconductor optical amplifier sections are arranged for amplitude modulation purposes.

Hence, the information signal may be an electrical signal driving the amplitude modulation stage.

According to a next embodiment, the information signal comprises at least one of the following:

- an electrical signal driving the phase modulation stage;
- an electrical signal driving the amplitude modulation stage.

Hence, the information signal may comprise a combination of an electrical signal driving the phase modulation and another electrical signal driving the amplitude modulation; the electrical signals are applied to at least two semiconductor optical amplifier sections, wherein if the electrical signal is applied to one semiconductor optical amplifier section, the inverse electrical signal (together with the factor K) is applied to another semiconductor optical amplifier section. This allows efficient amplitude modulation or amplitude and phase modulation of an optical signal. Hence, for that purpose at least two semiconductor optical amplifier sections are required as combined electrical signals could be applied to any semiconductor optical amplifier section.

The problem stated above is also solved by a method for operating an optical modulator comprising at least two semiconductor optical amplifier sections that are arranged in a cascaded structure, wherein an information signal is applied to one of the semiconductor optical amplifier sections and an inverse information signal is applied to another of the semiconductor optical amplifier sections.

It is noted that the features described with regard to the modulator apply accordingly for said method. Basically, the method can be used to operate the modulator. In particular, a processing unit can be provided that is arranged such that the modulator is operated accordingly. The processing unit can comprise at least one, in particular several means that are arranged to execute the steps of the method described herein. The means may be logically or physically separated; in particular several logically separate means could be combined in at least one physical unit.

Said processing unit may comprise at least one of the following: a processor, a microcontroller, a hard-wired circuit, an ASIC, an FPGA, a logic device.

According to an embodiment, the inverse information signal is multiplied by a factor K and the factor K results in K = $\alpha_2$ / $\alpha_1$, wherein $\alpha_1$ describes a ratio between the amplitude modulation and the phase modulation of a first semiconductor optical amplifier section and $\alpha_2$ describes a ratio between the amplitude modulation and the phase modulation of a second semiconductor optical amplifier section.

Pursuant to yet an embodiment, the information signal comprises at least one of the following:

- an electrical signal driving the phase modulation;
- an electrical signal driving the amplitude modulation.

Furthermore, the problem stated above is solved by a communication system comprising at least one modulator as described herein.

Embodiments of the invention are shown and illustrated in the following figures:

Fig.1     shows a schematic of a semiconductor optical amplifier (SOA) section;

Fig.2     shows a SOA structure comprising two sections to obtain amplitude modulation, wherein an information signal is applied to a first section and the inverted information signal multiplied by a factor K is applied to a second section of the SOA structure;

Fig.3     shows a schematic diagram depicting an operation scheme of a SOA structure with two sections to obtain amplitude modulation;

Fig.4     shows three schematics of semiconductor optical amplifiers to obtain controlled AM and PM comprising four, three and two sections.

It is suggested using a multi-electrode SOA structure to generate a pure AM optical signal or an optical signal with independent AM and PM in particular with an optical gain.

Thus, optical signals may be generated with advanced modulation formats (e.g., OSSB, DPSK) for access or RoF networks.

Amplitude Modulation only: Conceptual Approach

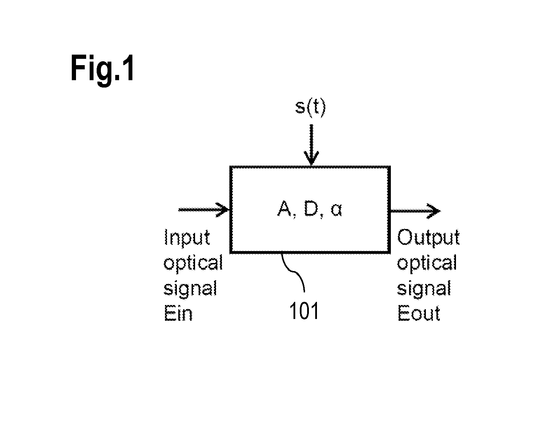

**Fig.1** shows a schematic of a semiconductor optical amplifier section 101. The amplifier section 101 induces gain (amplitude) and phase modulation over an input signal $E_{in}$ as a function of an AC-coupled driving signal s(t). For simplicity reasons, a DC-driving signal (offset) is not shown in Fig.1.

An output signal $E_{out}$ of the semiconductor optical amplifier section 101 can be described as

$$E_{out}(t) = E_{in}(t) \cdot \sqrt{G} \cdot \exp\left\{j \cdot \frac{\alpha}{2} \cdot (\ln(G) + \gamma)\right\} \qquad (1)$$

wherein

$E_{in}(t)$  corresponds to an electrical field of the optical signal at the input of the semiconductor optical amplifier section 101;

$E_{out}(t)$  corresponds to an electrical field of the optical signal at the output of the semiconductor optical amplifier section 101;

$G$  is an optical power gain;

$\alpha$  describes a ratio between the amplitude modulation and the phase modulation ($\alpha$ is also known as linewidth enhancement factor); and

$\gamma$  is a rate of cavity loss caused by facet and waveguide losses.

In case the input signal varies in a scale of time below a SOA recovery time and the input power is low to prevent gain saturation, it can be assumed that the gain is based on the modulating signal s(t) as follows:

$$G \approx \exp\left[A(s(t) + D)\right] \qquad (2)$$

wherein A and D are constants that describe the relationship between the amplifier gain and the modulating signal.

The output signal can then be described as:

$$E_{out}(t) = E_{in}(t) \cdot \sqrt{\exp\left[A \cdot (s(t) + D)\right]} \cdot \exp\left\{j \cdot \frac{\alpha}{2} \cdot \left[A \cdot (s(t) + D) + \gamma\right]\right\} \qquad (3)$$

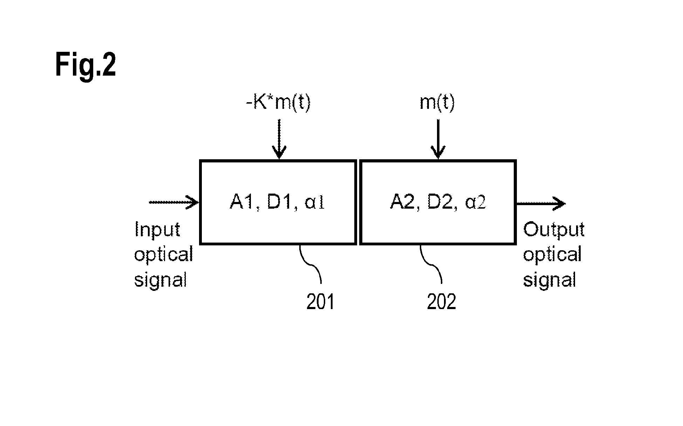

**Fig.2** shows a SOA structure comprising two sections 201 and 202 to obtain amplitude modulation. An information signal m(t) is applied to the section 202 and the inverted information signal -m(t) multiplied by a factor K is applied to the section 201. The signal at the output of the SOA structure can be described by applying equation (1) to the two sections 201, 202:

$$E_{out}(t) = E_{in}(t) \cdot \sqrt{\exp\left[A_1 \cdot (-K \cdot m(t) + D_1)\right]} \cdot \exp\left\{ j \cdot \frac{\alpha_1}{2} \cdot \left[A_1 \cdot (-K \cdot m(t) + D_1) + \gamma_1\right] \right\} \cdot$$
$$\cdot \sqrt{\exp\left[A_2 \cdot (m(t) + D_2)\right]} \cdot \exp\left\{ j \cdot \frac{\alpha_2}{2} \cdot \left[A_2 \cdot (m(t) + D_2) + \gamma_2\right] \right\} \tag{4}$$

wherein K (K<1) represents an attenuation.

Assuming that

$A_2 \approx A_1 = A$;

$D2 \approx D_1 = D$; and

$\gamma_1 \approx \gamma_2 = \gamma$

and rearranging equation (4) results in:

$$E_{out}(t) \approx E_{in}(t) \cdot \sqrt{\exp\left[A \cdot (m(t)(1-K) + 2 \cdot D)\right]} \cdot$$
$$\cdot \exp\left\{ j \cdot \left[ m(t) \cdot \frac{A}{2}(-K \cdot \alpha_1 + \alpha_2) + \frac{A \cdot D}{2}(\alpha_1 + \alpha_2) + \frac{\gamma}{2}(\alpha_1 + \alpha_2) \right] \right\} \tag{5}$$

In order to achieve AM only, the following condition is to be met

$$-K \cdot \alpha_1 + \alpha_2 = 0$$

which can be achieved by controlling the factor K as follows:

$$K = \frac{\alpha_2}{\alpha_1}$$

In case

$$\alpha_1 \gg \alpha_2;$$

$$K \ll 1$$

equation (3) can be arranged to

$$E_{out}(t) \approx E_{in}(t) \cdot \sqrt{\exp\left[A \cdot (m(t) + 2 \cdot D)\right]} \cdot \exp\left\{ j \cdot \frac{\alpha_1}{2}(A \cdot D + \gamma) \right\} \tag{6}$$

It can be shown that equation (6) does not have any phase modulation; furthermore, the optical power is modulated by the information signal m(t).

In case

$$A \cdot m(t) \ll 1$$

the optical power is modulated with the data signal and the output signal amounts to

$$E_{out}(t) \approx E_{in}(t) \cdot \sqrt{\exp[A \cdot 2 \cdot D] \cdot (1 + A \cdot m(t))} \cdot \exp\left\{ j \cdot \frac{\alpha_1}{2}(A \cdot D + \gamma) \right\} \qquad (7)$$

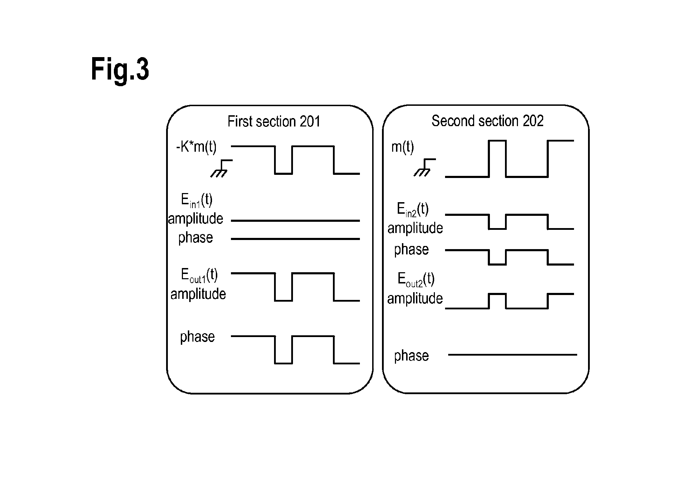

The operation of this scheme is illustrated in **Fig.3** for square waveforms. As can be seen, at an input $E_{in1}$ of the first section 201 there is no intensity or phase modulation. After the first section (i.e., at an output $E_{out1}$ of the first section 201) the intensity and phase of the optical signal are modulated with the inverse of the attenuated input data signal. This signal is then fed to the second section 202. The data signal is driving this section, but with a higher amplitude than in the first section 201.

By properly controlling the attenuation in the first section 201 in relation to $\alpha_1/\alpha_2$, cancellation of the PM is achieved, but the AM is preserved.

On the other hand, if $A \cdot m(t)$ is not negligible (when compared to 1), the data signals driving the SOA can be pre-distorted with a logarithmic function so that the output signal power is still proportional to the data signal.

Amplitude Modulation only: Exemplary Implementation

The proposed solution suggests a SOA with two active sections or two cascaded SOA sections comprising distinct linewidth enhancement factors $\alpha_1, \alpha_2$. The linewidth enhancement factors can be controlled by a bias DC current. The relation between linewidth enhancement factor and bias current is described, e.g., in T. N. Nielsen, et al., "Cancellation of inherent AM in semiconductor optical amplifier phase modulators", in Electron. Lett., vol. 28, no. 3, 30.01.1992, pp. 235-236 or in N. Storkfelt et al., "Measurement of carrier lifetime and linewidth enhancement factor for 1.5-mu m ridge-waveguide laser amplifier", in IEEE Photon. Technol. Lett., vol. 3, no. 7, July 1991, pp. 632-634. For such purpose, a SOA with two electrodes or two cascaded SOAs may be employed.

It is noted that since the SOA bias current is different in the two electrodes, so are the A and D parameters; therefore the K factor can be calculated as follows:

$$K = \frac{\alpha_1 A_1}{\alpha_2 A_2}$$

The solution presented herein in particular adjusts the K factor to minimize the AM.

The order of the two sections 201, 202 can be changed; however, preferably, the section driven by the electrical signal with lower amplitude may be the first section, which is beneficial in order to reduce signal distortion due to Self-Gain and Self-Phase modulation.

Independent Amplitude and Phase Modulation

It is further suggested generating an optical signal with independent AM and PM. This objective may be met by using a semiconductor optical amplifier comprising four sections or four cascaded SOAs.

In the first two sections, PM may be conducted as described in T. N. Nielsen, et al., "Cancellation of inherent AM in semiconductor optical amplifier phase modulators", in Electron. Lett., vol. 28, no. 3, 30.01.1992, pp. 235-236.

In the remaining two sections, AM can be conducted accordingly as described above under "amplitude modulation only".

The order of sections performing PM and AM is interchangeable. Nevertheless, the order indicated above may be preferred.

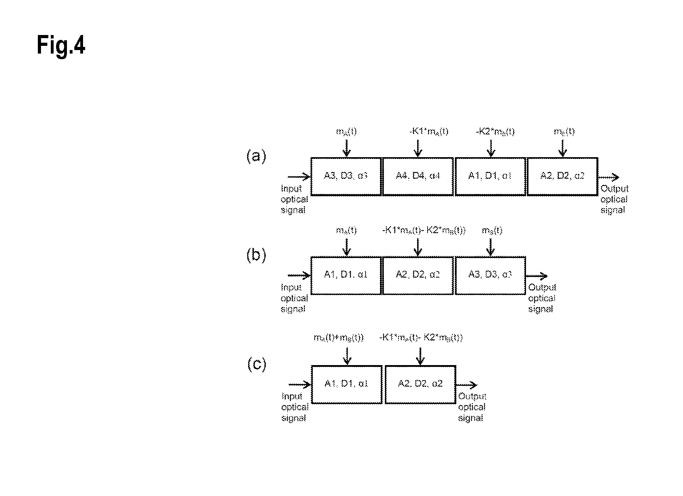

**Fig.4** shows three schematics of semiconductor optical amplifiers to obtain controlled AM and PM comprising four, three and two sections. A signal $m_A(t)$ is an electrical signal driving the PM and a signal $m_B(t)$ is an electrical signal driving the AM. As a result of this proposal, it is possible to perform AM and PM in the same device, with gain.

The number of semiconductor optical amplifier sections can be reduced from four to three or two as shown in (a) to (c) of Fig.4.

The exemplary implementations (a) and (b) may be preferred, because they may be more cost efficient, as the SOA can be directly integrated with the laser source. Furthermore, amplitude and phase modulation can be controlled independently. Since semiconductor sections are used, optical gain is expected, which is a key factor for low cost access networks or passive optical networks.

**List of Abbreviations:**

AC          Alternating Current

AM          Amplitude Modulation

CS-RZ       Carrier-Suppressed Return-to-Zero

DC          Direct Current

DPSK        Differential PSK

DQPSK       Differential QPSK

DWDM        Dense Wavelength Division Multiplexing

MZM         Mach-Zehnder Modulator

OOK         On-Off Keying

OSSB        optical Single Sideband

PM          Phase Modulation

PSK         Phase Shift Keying

QPSK        Quadrature PSK

RoF         Radio over Fiber

SOA         Semiconductor Optical Amplifier

**Claims**

1.  An optical modulator

    - comprising at least two semiconductor optical amplifier sections that are arranged in a cascaded structure;
    - wherein an information signal is applicable to one of the semiconductor optical amplifier sections and an inverse information signal is applicable to another of the semiconductor optical amplifier sections.

2.  The modulator according to claim 1, wherein the modulator is used for

    - OSSB modulation;
    - DPSK modulation;
    - DQPSK modulation;
    - CS-RZ modulation;
    - substantially chirp-free OOK modulation.

3.  The modulator according to any of the preceding claims, wherein the modulator comprises two, three or four semiconductor optical amplifier sections.

4. The modulator according to any of the preceding claims, wherein the inverse information signal is multiplied by a factor K.

5. The modulator according claim 4, wherein the factor K amounts to

$$K = \alpha_2 / \alpha_1,$$

wherein $\alpha_1$ describes a ratio between the amplitude modulation and the phase modulation of a first semiconductor optical amplifier section and $\alpha_2$ describes a ratio between the amplitude modulation and the phase modulation of a second semiconductor optical amplifier section.

6. The modulator according to claim 5, wherein the ratio between the amplitude modulation and the phase modulation of the first semiconductor optical amplifier section and the ratio between the amplitude modulation and the phase modulation of the second semiconductor optical amplifier section are controlled in particular by a bias current or by amplifier design.

7. The modulator according to claim 6, wherein the semiconductor optical amplifier section driven by bias current of lower amplitude is arranged prior to a subsequent semiconductor optical amplifier section that is driven by the bias current of higher amplitude.

8. The modulator according to any of the preceding claims, wherein the modulator is used in an access network or in a radio-over-fiber network.

9. The modulator according to any of the preceding claims, wherein at least two subsequent semiconductor optical amplifier sections are arranged for phase modulation purposes.

10. The modulator according to any of the preceding claims, wherein at least two subsequent semiconductor optical amplifier sections are arranged for amplitude modulation purposes.

11. The modulator according to any of the preceding claims, wherein the information signal comprises at least one of the following:

- an electrical signal driving the phase modulation stage;
- an electrical signal driving the amplitude modulation stage.

12. A method for operating an optical modulator comprising at least two semiconductor optical amplifier sections that are arranged in a cascaded structure,

- wherein an information signal is applied to one of the semiconductor optical amplifier sections and an inverse information signal is applied to another of the semiconductor optical amplifier sections.

13. The method according to claim 12,

- wherein the inverse information signal is multiplied by a factor K;
- wherein the factor K results in

$$K = \alpha_2 / \alpha_1,$$

wherein $\alpha_1$ describes a ratio between the amplitude modulation and the phase modulation of a first semiconductor optical amplifier section and $\alpha_2$ describes a ratio between the amplitude modulation and the phase modulation of a second semiconductor optical amplifier section.

**14.** The method according to any of claims 12 or 13, wherein the information signal comprises at least one of the following:

- an electrical signal driving the phase modulation;
- an electrical signal driving the amplitude modulation.

**15.** A communication system comprising at least one modulator according to any of claims 1 to 11.

# Fig.1

s(t)

A, D, α

Input
optical
signal
Ein

101

Output
optical
signal
Eout

# Fig.2

```
      -K*m(t)              m(t)
         |                  |
         v                  v
    +----------+       +----------+
--> | A1, D1, αl |     | A2, D2, α2 | -->
    +----------+       +----------+
Input                              Output
optical                            optical
signal        201       202        signal
```

# Fig.3

First section 201

-K*m(t)

$E_{in1}(t)$
amplitude
phase

$E_{out1}(t)$
amplitude

phase

Second section 202

m(t)

$E_{in2}(t)$
amplitude
phase

$E_{out2}(t)$
amplitude

phase

# Fig.4

Europäisches
Patentamt

European
Patent Office

Office européen
des brevets

# EUROPEAN SEARCH REPORT

Application Number

EP 10 15 6342

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | NIELSEN T N ET AL: "CHIRP-FREE 2.5 GBIT/S AMPLITUDE MODULATION/GATING IN TWO-ELECTRODE SEMICONDUCTOR OPTICAL AMPLIFIERS" PROCEEDINGS OF THE EUROPEAN CONFERENCE ON OPTICAL COMMUNICATION (ECOC) REGULAR PAPERS. BERLIN, SEPT. 27 - OCT. 1, 1992. BOUND AS ONE WITH VOLUMES 2 & 3; [PROCEEDINGS OF THE EUROPEAN CONFERENCE ON OPTICAL COMMUNICATION (ECOC)], FRANKFURT, IGVDE, DE, vol. 1, 27 September 1992 (1992-09-27), pages 385-388, XP000628185 ISBN: 978-3-8007-1896-2 | 1-4, 8-12,14, 15 | INV. H04B10/155 H01S5/50 |
| A | * the whole document * | 5-7,13 | |
| X | NIELSEN T N ET AL: "CANCELLATION OF INHERENT AM IN SEMICONDUCTOR OPTICAL AMPLIFIER PHASE MODULATORS" ELECTRONICS LETTERS, IEE STEVENAGE, GB LNKD- DOI:10.1049/EL:19920145, vol. 28, no. 3, 30 January 1992 (1992-01-30), pages 235-236, XP000305956 ISSN: 0013-5194 | 1-4, 8-12,14, 15 | |
| A | * the whole document * | 5-7,13 | |
| A | GUEKOS G ET AL: "Phase modeling based on the /spl alpha/-factor in bulk semiconductor optical amplifiers" IEEE JOURNAL OF SELECTED TOPICS IN QUANTUM ELECTRONICS, IEEE SERVICE CENTER, PISCATAWAY, NJ, US LNKD- DOI:10.1109/JSTQE.2003.818346, vol. 9, no. 3, 1 May 2003 (2003-05-01), pages 788-797, XP011103902 ISSN: 1077-260X * the whole document * | 1-15 | |

TECHNICAL FIELDS SEARCHED (IPC)

H04B
H01S

The present search report has been drawn up for all claims

| Place of search | Date of completion of the search | Examiner |
|---|---|---|
| Munich | 20 August 2010 | Petitit, Nicolas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
.....................................................................................
& : member of the same patent family, corresponding document

EPO FORM 1503 03.82 (P04C01)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **T. N. NIELSEN et al.** Cancellation of inherent AM in semiconductor optical amplifier phase modulators. *Electron. Lett.,* 30 January 1992, vol. 28 (3), 235-236

- **N. STORKFELT et al.** Measurement of carrier lifetime and linewidth enhancement factor for 1.5-mu m ridge-waveguide laser amplifier. *IEEE Photon. Technol. Lett.,* July 1991, vol. 3 (7), 632-634